# EUROPÄISCHE PATENTSCHRIFT

(11) **EP 1 256 637 B1**
(45) Veröffentlichungstag und Bekanntmachung des Hinweises auf die Patenterteilung: **30.11.2005**
(21) Anmeldenummer: 02405317.5
(22) Anmeldetag: 18.04.2002
(51) Int. Cl.: C23C 14/50

(54) **Werkstückträger**
Substrate holder
Porte-pièce

(30) Priorität: 08.05.2001 CH 8302001
(43) Veröffentlichungstag der Anmeldung: 13.11.2002
(73) Patentinhaber: Unaxis Balzers Aktiengesellschaft, 9496 Balzers (LI)
(72) Erfinder: Giacri, Laurent, 42400 Saint-Chamond (FR); Kunz, Anton, 9497 Triesenberg (LI)
(74) Vertreter: Wagner, Wolfgang Heribert

(56) Entgegenhaltungen:
- WO-A-00/36178
- DE-A- 19 803 278

## Beschreibung

### Technisches Gebiet

Die Erfindung betrifft einen Werkstückträger für eine Beschichtungsanlage gemäss dem Oberbegriff des Anspruchs 1, insbesondere für den Einsatz in einer Vakuumbeschichtungsanlage. Ein Werkstückträger dieser Art trägt gewöhnlich eine grössere Anzahl von Werkstücken, derart, dass sie zur Gewährleistung einer gleichmässigen Beschichtung in einer z. B. durch Ueberlagerung mehrerer elementarer Bewegungen - meist Kreisbewegungen - erzeugten zusammengesetzten Bewegung an Beschichtungsquellen vorbeilaufen und sich zugleich drehen.

### Stand der Technik

Es sind Werkstückträger bekannt, bei welchen die Mitnehmer jeweils an einer zum Schaft parallelen neben den Tellern durchlaufenden Stange angebracht sind. Dies hat den Nachteil, dass, wenn die Abstände zwischen den Tellern in Anpassung an die Länge der Werkstücke geändert werden, die Mitnehmer entsprechend verschoben und neu justiert werden müssen, was mit beträchtlichem Aufwand verbunden ist und insbesondere mehrere Probeläufe erfordert. Wenn ein Teller ausgewechselt wird, muss der Mitnehmer ebenfalls ausgewechselt oder mindestens neu justiert werden. Eine Fehljustierung kann gravierende Konsequenzen haben.

Eine konstruktiv der bekannten gattungsgemässen ähnliche Lösung, bei der allerdings die Möglichkeit, die Abstände zwischen den Tellern zu ändern oder Teller auszuwechseln, nicht vorgesehen ist, ist etwa der DE-A-198 03 278 zu entnehmen.

Aus der WO-A-00/36 178 ist u. a. ein gattungsgemässer Werkstückträger zu entnehmen, bei welchem jedem Teller ein auf dessen Oberseite drehbar abgestützter Mitnehmer zugeordnet ist. Der Mitnehmer ist jedoch nicht fest mit dem Teller verbunden, so dass er bei Aenderungen am Werkstückträger in der Regel neu aufgesetzt und justiert werden muss.

### Darstellung der Erfindung

Der Erfindung liegt die Aufgabe zu Grunde, einen gattungsgemässen Werkstückträger zur Verfügung zu stellen, bei welchem Anpassungen an die jeweiligen Werkstückgeometrien und an andere Anforderungen an den Beschichtungsprozess, beispielsweise durch Aenderungen der Abstände zwischen den Tellern oder auch durch Auswechseln von Tellern, leicht und ohne grösseren Aufwand möglich sind.

Diese Aufgabe wird durch die erfindungsgemässen Merkmale im kennzeichnenden Teil des Anspruchs 1 gelöst.

Die durch die Erfindung erreichten Vorteile sind vor allem darin zu sehen, dass der jeweilige Mitnehmer lediglich einmal justiert zu werden braucht. Insbesondere machen Aenderungen der Abstände zwischen den Tellern oder das Auswechseln einzelner Teller keine Neujustierung erforderlich. Selbst die einmalige Justierung kann am einzelnen Teller vorgenommen werden, ohne dass andere Anlagenbestandteile einbezogen werden müssten. Gemäss der Erfindung ausgebildete Teller können meist leicht in bestehende Beschichtungsanlagen integriert werden.

Die Erfindung gestattet einen Aufbau des Werkstückträgers aus einzelnen Bausteinen, insbesondere den jeweils eine kompakte und robuste Einheit bildenden Tellern, die nach dem Baukastenprinzip zusammengesetzt werden können und, abgesehen von der kraftübertragenden Schaft/Teller-Passung und einem ähnlichen Aussendurchmesser der Teller, nicht besonders aufeinander abgestimmt sein müssen. Dadurch können etwa die Teller unterschiedlich ausgebildet sein, ohne dass dies Anpassungen anderer Anlagenteile erfordern würde.

Insbesondere können auf ein- und demselben Werkstückträger gleichzeitig Teller unterschiedlicher Ausbildung verwendet werden. Sie können etwa in Anpassung an die jeweilige Werkstückgeometrie mit unterschiedlicher Teilung, d. h. verschiedener Anzahl von Werkstückaufnahmen versehen oder in Anpassung an spezifische Anforderungen die Beschichtung der auf ihnen angeordneten Werkstücke betreffend z. B. für intermittierende oder kontinuierliche Werkstückdrehung ausgebildet sein. Es können auch erfindungsgemäss und herkömmlich ausgebildete Drehteller in einem Werkstückträger kombiniert werden.

In jedem Fall kann die Mitnahmevorrichtung ganz oder überwiegend ausserhalb der Umlaufbahn der Werkstücke angebracht werden und der Mitnehmer vom Rand des Drehtellers her mit den Werkstückaufnahmen eingreifen, so dass den Beschichtungsprozess störende die Werkstücke übergreifende Bestandteile nicht erforderlich sind. Gleichzeitig kann jedoch die Mitnahmevorrichtung platzsparend ausgebildet und angeordnet sein, so dass erfindungsgemäss ausgebildete Teller im Vergleich mit herkömmlichen Tellern gleiche oder nur geringfügig grössere Bauhöhe aufweisen.

### Kurze Beschreibung der Zeichnungen

Im folgenden wird die Erfindung anhand von Figuren, welche lediglich ein Ausführungsbeispiel darstellen, näher erläutert. Es zeigen
- Fig. 1: eine teilweise geschnittene Seitenansicht eines Teils eines erfindungsgemässen Werkstückträgers und
- Fig. 2: eine Draufsicht auf den Werkstückträger von Fig. 1.

### Wege zur Ausführung der Erfindung

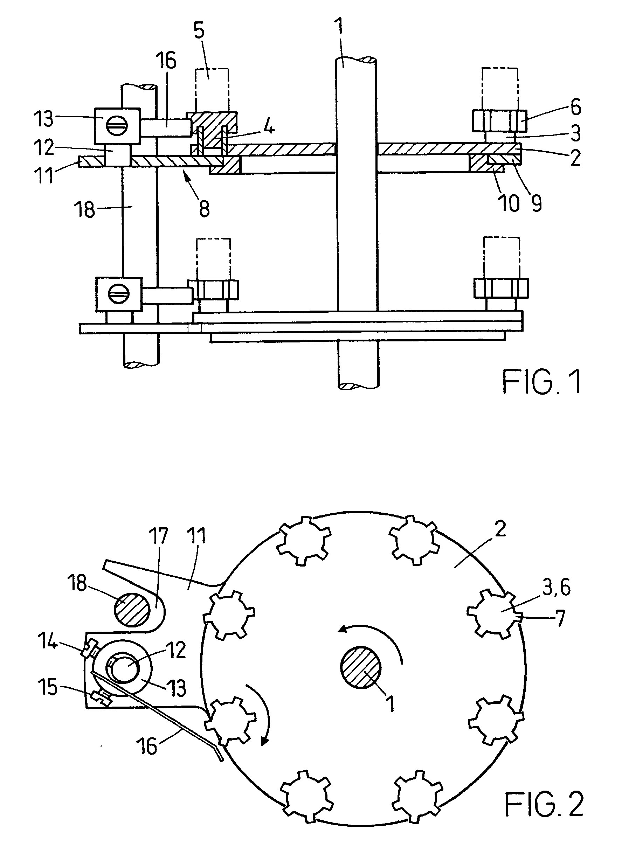

In einer Basis (nicht dargestellt), welche fest oder auch beweglich, z. B. drehbar in einer Vakuumkammer angeordnet sein kann, ist drehbar ein vertikaler Schaft 1 gelagert, welcher antreibbar ist, so dass er eine Drehung gemäss Pfeil in Fig. 2 um eine mit seiner Achse zusammenfallende Hauptdrehachse ausführt. Am Schaft 1 sind mit Abstand aufeinanderfolgend Teller 2 drehfest befestigt, welche jeweils in Randnähe mehrere vom Schaft 1 gleich weit beabstandete Werkstückaufnahmen 3 tragen, die jeweils mittels eines Achszapfens 4 um eine zur Hauptdrehachse parallele Drehachse drehbar am Teller 2 gelagert sind. Die Teller können zwecks Gewichts- und Materialersparnis, aber auch um ein möglichst gleichförmiges Umfassen der Werkstücke durch Plasma oder einen ungehinderten Teilchenbeschuss zu ermöglichen, auch in Leichtbauweise, z. B. als Speichenteller ausgeführt sein.

Die Werkstückaufnahmen 3 sind gleichmässig über den Umfang des jeweiligen Tellers 2 verteilt, so dass sie ein regelmässiges Vieleck, im dargestellten Fall Achteck bilden, in dessen Zentrum die Hauptdrehachse liegt. Im Einsatz trägt jede der Werkstückaufnahmen 3 ein Werkstück 5 (Fig. 1, strichpunktiert). Die Abstände zwischen aufeinanderfolgenden Tellern 2 können in Anpassung an die Länge der Werkstücke geändert werden. Die Teller 2 können bei kreisförmigem Profil des Schaftes 1 z. B. durch Nut/Nase- oder ähnlich einfache Passungen oder auch durch lösbare Schraubverbindungen, etwa durch Klemmschrauben, am Schaft 1 befestigt sein. Bei anderen Schaftprofilen erübrigen sich im allgemeinen zusätzliche Massnahmen zur Befestigung des Tellers am Schaft. Zur Fixierung der Positionen der Teller 2 können Abstandhalter eingesetzt werden, beispielsweise hier nicht dargestellte auf den Schaft aufgesteckte Hülsen, die jeweils auf einem am unteren Ende des Schafts umlaufenden Vorsprung oder auf einem der Teller 2 sitzen.

Jede der Werkstückaufnahmen 3 weist ein am oberen Ende des Achszapfens 4 angeordnetes, zu ihrer Drehachse koaxiales Treibrad 6 mit regelmässig über den Umfang verteilten nach aussen vorspringenden Zähnen 7 auf, die wie im Beispiel durch Zwischenräume getrennt sein können.

Am Teller 2 ist ausserdem eine Mitnahmevorrichtung 8 gelagert, welche einen mit dem Schaft 1 koaxialen Drehring 9 umfasst, der durch einen innerhalb desselben an der Unterseite des Tellers 2 befestigten, den Drehring 9 mit einem an seiner Aussenseite umlaufenden Sims untergreifenden Ringhalter 10 derart gehalten wird, dass er gegen Verschiebung parallel zur Hauptdrehachse gesichert, aber demselben gegenüber um sie drehbar ist. Weiter weist die Mitnahmevorrichtung 8 einen vom Drehring 9 nach aussen vorspringenden Fortsatz 11 auf, der einen parallel zum Schaft 1 nach oben weisenden Zapfen 12 trägt, an welchem ein Befestigungsring 13 mittels einer Befestigungsschraube 14 befestigt ist. In einer Nut des Befestigungsrings 13 ist längsverschieblich, aber durch eine Feststellschraube 15 festgelegt ein als gegen den Rand des Tellers 2 gerichteter Mitnehmerfinger 16 ausgebildeter Mitnehmer gehaltert. Die Befestigungsschraube 14 und die Feststellschraube 15 sind Klemmschrauben, der Mitnehmerfinger 16 eine Lasche aus Federstahl.

Die Lage des Mitnehmerfingers 16 kann in mehrfacher Hinsicht justiert werden. Der Befestigungsring 13 kann nach Lösen der Befestigungsschraube 14 längs des Zapfens 12, d. h. parallel zum Schaft 1 verschoben und in der dazu normalen Ebene gedreht werden. Seine wirksame Länge kann durch Längsverschieben nach Lösen der Feststellschraube 15 eingestellt werden.

Neben dem Zapfen 12 weist der Fortsatz 11 eine buchtartig von der Aussenseite her einspringende Ausnehmung 17 auf, durch welche eine an der Basis verankerte, zum Schaft 1 parallele Stange 18 ragt. Sie dient als Anschlag, der mit den Mitnahmevorrichtungen 8 aller am Schaft 1 angebrachten Teller 2 derart eingreift, dass diese hinsichtlich ihrer Winkellage festgelegt und daran gehindert sind, sich mit dem jeweiligen Teller 2 mitzudrehen.

Bei Drehung des Schaftes 1 und der an ihm befestigten Teller 2 um die Hauptdrehachse kommt jede der Werkstückaufnahmen 3, ihrer Kreisbahn folgend, bei jeder Umdrehung ein Mal mit dem Mitnehmerfinger 16 in Kontakt. Er greift vorübergehend mit einem der Zähne 7 am Treibrad 6 ein und bewirkt dadurch eine dem Drehsinn des Tellers 2 entgegengesetzte Drehung der entsprechenden Werkstückaufnahme 3 dem Teller 2 gegenüber, derart, dass am Ende des Eingriffs der in Drehrichtung des Tellers 2 nächste Zahn im wesentlichen die Position einnimmt, die vor dem Eingriff der erstgenannte Zahn eingenommen hatte. Dem Teller 2 gegenüber wird also die Werkstückaufnahme 3 durch den Eingriff des Mitnehmerfingers 16 mit dem Treibrad 6 um die Winkeldifferenz zwischen zwei aufeinanderfolgenden Zähnen - im Beispiel 60° - entgegen der Drehrichtung des Tellers 2 gedreht. Da der Mitnehmer nur mit dem Teller 2 verbunden ist, kann die Justierung desselben unabhängig von anderen Anlagenteilen am isolierten Teller erfolgen. Ausbau und Wiedereinbau desselben, z. B. zwecks Aenderung der Abstände der längs des Schaftes 1 vertikal aufeinanderfolgend angeordneten Teller 2, erfordert keine Neujustierung des Mitnehmers.

Die Mitnahmevorrichtung kann bei allen, aber auch bei einzelnen Tellern anders als beschrieben ausgebildet sein. So muss der Fortsatz keine Ausnehmung aufweisen, da ein einseitig gegen die Drehrichtung des Tellers wirksamer Anschlag genügt. Die Treibräder können jeweils eine kontinuierliche Verzahnung aufweisen oder als Malteserkreuze oder - auch unterschiedlich ausgeführte - Reibräder ausgebildet sein. Der Mitnehmer kann statt als Mitnehmerfinger als dem Rand des Tellers folgender Mitnehmerkranz mit Innenverzahnung, bevorzugt - da in diesem Fall besonders einfach herstellbar - als zylindrisches Blech mit Zahnprofil ausgebildet sein, wobei die Verzahnung mit den Verzahnungen der Treibräder eingreift, so dass die Werkstückaufnahmen statt intermittierend kontinuierlich gedreht werden.

Vor allem an Tellern mit kontinuierlich drehenden Werkstückaufnahmen wird bevorzugt eine Sollbruchstelle vorgesehen, die im Fall des Verklemmens der Mitnahmevorrichtung oder einer Werkstückaufnahme an einem Teller grösseren Schaden verhindert. Dies kann so geschehen, dass der Fortsatz eine Stelle verringerten Querschnitts aufweist, an der er bei Ueberschreiten eines bestimmten Drehmoments bricht und die Drehung des Tellers wieder freigibt, während zugleich die Fehlfunktion desselben signalisiert wird. Eine ähnliche Wirkung kann erzielt werden, indem der Fortsatz gefedert ausgebildet oder über ein Gelenk befestigt wird. Alternativ oder zusätzlich können Sollbruchstellen an der Passung Schaft/Teller und an den Treibrädern oder Achszapfen der Werkstückaufnahmen vorgesehen werden. Letztere können dabei als kostengünstige Wegwerfteile ausgeführt sein.

Bei Verwendung eines Gelenks kann eine Sollbruchstelle angelegt werden, indem dasselbe mittels eines Drahtes, insbesondere eines Kupferdrahtes mit definierter Scherfestigkeit gesichert ist, so dass es erst bei Ueberschreiten der Bruchlast desselben eine Klappbewegung ausführt. In diesem Fall kann eine gebrochene Sollbruchstelle einfach und ohne grossen Aufwand vom Bedienungspersonal der Beschichtungsanlage vor Ort in Stand gesetzt werden. Auch an anderen kraftübertragenden Teilen wie z. B. Treibrädern können in ähnlicher Weise Sollbruchstellen vorgesehen werden, indem dieselben aus zwei oder mehr Bestandteilen aufgebaut werden, welche durch Drähte definierter Scherfestigkeit verbunden sind.

### Bezugszeichenliste

- 1: Schaft
- 2: Teller
- 3: Werkstückaufnahme
- 4: Achszapfen
- 5: Werkstück
- 6: Treibrad
- 7: Zahn
- 8: Mitnahmevorrichtung
- 9: Drehring
- 10: Ringhalter
- 11: Fortsatz
- 12: Zapfen
- 13: Befestigungsring
- 14: Befestigungsschraube
- 15: Feststellschraube
- 16: Mitnehmerfinger
- 17: Ausnehmung
- 18: Stange

## Patentansprüche

1. Werkstückträger für eine Beschichtungsanlage, mit einer Basis, in welcher mindestens ein antreibbarer Schaft (1) um eine Hauptdrehachse drehbar verankert ist, an dem mehrere einstellbar in Achsrichtung voneinander beabstandete Teller (2) drehfest angebracht sind, von denen jeder mindestens eine Werkstückaufnahme (3) trägt, welche um eine zur Hauptdrehachse parallele Drehachse drehbar am Teller (2) gelagert ist sowie mit Mitnehmern, von denen jeder einem Teller (2) zugeordnet ist, derart, dass er mindestens intermittierend mit der mindestens einen Werkstückaufnahme (3) eingreift und **dadurch** Drehung derselben um deren Drehachse bewirkt, **dadurch gekennzeichnet, dass** der einem Teller (2) zugeordnete Mitnehmer jeweils einer um die Hauptdrehachse drehbar, aber im übrigen unverschieblich am Teller (2) befestigten Mitnahmevorrichtung (8) zugehört, welche mit einem ihre Verdrehung mindestens einseitig begrenzenden an der Basis verankerten Anschlag zusammenwirkt.

2. Werkstückträger nach Anspruch 1, **dadurch gekennzeichnet, dass** der Mitnehmer mit der jeweils der Hauptdrehachse abgewandten Seite der mindestens einen Werkstückaufnahme (3) eingreift.

3. Werkstückträger nach Anspruch 1 oder 2, **dadurch gekennzeichnet, dass** die Lage des Mitnehmers relativ zu den Werkstückaufnahmen (3) justierbar ist.

4. Werkstückträger nach einem der Ansprüch 1 bis 3, **dadurch gekennzeichnet, dass** der Anschlag für alle Mitnahmevorrichtungen (8) von einer zum Schaft (1) parallelen Stange (18) gebildet wird, indem jede von ihnen einen über den Rand des jeweiligen Tellers (2) hinausragenden Fortsatz (11) aufweist, welcher mit der Stange (18) eingreift.

5. Werkstückträger nach Anspruch 4, **dadurch gekennzeichnet, dass** der Fortsatz (11) eine buchtartige Ausnehmung (17) aufweist, welche die Stange (18) aufnimmt.

6. Werkstückträger nach einem der Ansprüche 1 bis 5, **dadurch gekennzeichnet, dass** die Mitnahmevorrichtung (8) jeweils an der Unterseite des Tellers (2) gelagert ist.

7. Werkstückträger nach einem der Ansprüche 1 bis 6, **dadurch gekennzeichnet, dass** die Mitnahmevorrichtung (8) einen mit dem Teller (2) koaxialen Drehring (9) umfasst.

8. Werkstückträger nach den Ansprüchen 6 und 7, **dadurch gekennzeichnet, dass** an der Unterseite des Tellers (2) ein Ringhalter (10) innerhalb des Drehrings (9) befestigt ist, welcher denselben untergreift.

9. Werkstückträger nach einem der Ansprüche 1 bis 8, **dadurch gekennzeichnet, dass** der Mitnehmer mindestens eines Tellers (2) intermittierend mit der mindestens einen Werkstückaufnahme (3) eingreift.

10. Werkstückträger nach Anspruch 9, **dadurch gekennzeichnet, dass** der Mitnehmer als gegen den Rand des Tellers (2) gerichteter Mitnehmerfinger (16) ausgebildet ist.

11. Werkstückträger nach Anspruch 10, **dadurch gekennzeichnet, dass** der Mitnehmerfinger (16) an einem Befestigungsring (13) sitzt, welcher auf einem zum Schaft (1) im wesentlichen parallelen Zapfen (12) mittels einer Befestigungsschraube (14) befestigt ist.

12. Werkstückträger nach Anspruch 11, **dadurch gekennzeichnet, dass** der Mitnehmerfinger (16) längsverschieblich am Befestigungsring (13) gelagert und mittels einer Feststellschraube (15) festlegbar ist.

13. Werkstückträger nach einem der Ansprüche 1 bis 8, **dadurch gekennzeichnet, dass** der Mitnehmer mindestens eines Tellers kontinuierlich mit der mindestens einen Werkstückaufnahme eingreift.

14. Werkstückträger nach Anspruch 13, **dadurch gekennzeichnet, dass** der Mitnehmer als Mitnehmerkranz mit Innenverzahnung, insbesondere als zylindrisches Blech mit Zahnprofil ausgebildet ist.

15. Werkstückträger nach einem der Ansprüche 1 bis 14, **dadurch gekennzeichnet, dass** an mindestens einem Teller (2) mindestens eine Sollbruchstelle vorgesehen ist, an welcher die Kraftübertragung zwischen dem Schaft (1) und dem Teller (2) oder zwischen dem Anschlag und der mindestens einen Werkstückaufnahme (3) über die Mitnahmevorrichtung (8) bei Ueberlastung unterbrochen wird.

16. Werkstückträger nach Anspruch einem der Ansprüche 1 bis 15, **dadurch gekennzeichnet, dass** er mindestens einen Teller (2) aufweist, dessen Mitnehmer intermittierend mit der mindestens einen Werkstückaufnahme (3) eingreift sowie mindestens einen weiteren Teller, dessen Mitnehmer kontinuierlich mit der mindestens einen Werkstückaufnahme eingreift.

## Claims

1. Workpiece support for a coating unit, comprising a base in which at least one drivable shaft (1) is anchored so as to be rotatable about a main axis of rotation, on which shaft a plurality of turntables (2) are nonrotatably mounted, which turntables are an adjustable distance apart in the axis direction and each of which carries at least one workpiece holder (3) which is mounted on the turntable (2) so as to be rotatable about an axis of rotation which is parallel to the main axis of rotation, and comprising drivers, each of which is coordinated with a turntable (2) in such a way that it engages at least intermittently with the at least one workpiece holder (3) and thus causes it to rotate about its axis of rotation, **characterized in that** the driver coordinated with a turntable (2) belongs to a driving device (8) which is fastened so as to be rotatable about the main axis of rotation but otherwise nondisplaceable on the turntable (2) and cooperates with a stop which limits its rotation at least on one side and is anchored on the base.

2. Workpiece support according to Claim 1, **characterized in that** the driver engages that side of the at least one workpiece holder (3) which faces away in each case from the main axis of rotation.

3. Workpiece support according to Claim 1 or 2, **characterized in that** the position of the driver relative to the workpiece holders (3) is adjustable.

4. Workpiece support according to any of Claims 1 to 3, **characterized in that** the stop for all driving devices (8) is formed by a rod (18) parallel to the shaft (1) by each of them having an extension (11) which projects beyond the edge of the respective turntable (2) and engages the rod (18).

5. Workpiece support according to Claim 4, **characterized in that** the extension (11) has a bay-like recess (17) which receives the rod (18).

6. Workpiece support according to any of Claims 1 to 5, **characterized in that** the driving device (8) is mounted in each case on the underside of the turntable (2).

7. Workpiece support according to any of Claims 1 to 6, **characterized in that** the driving device (8) comprises a rotating ring (9) coaxial with the turntable (2).

8. Workpiece support according to Claims 6 and 7, **characterized in that**, on the underside of the turntable (2), a ring retainer (10) is fastened inside the rotating ring (9) and grips under said rotating ring.

9. Workpiece support according to any of Claims 1 to 8, **characterized in that** the driver of at least one turntable (2) intermittently engages the at least one workpiece holder (3).

10. Workpiece support according to Claim 9, **characterized in that** the driver in the form of a driver finger (16) is directed towards the edge of the turntable (2).

11. Workpiece support according to Claim 10, **characterized in that** the driver finger (16) rests on a fastening ring (13) which is fastened by means of a fastening screw (14) to a peg (12) substantially parallel to the shaft (1).

12. Workpiece support according to Claim 11, **characterized in that** the driver finger (16) is mounted so as to be longitudinally displaceable on the fastening ring (13) and can be fixed by means of a setscrew (15).

13. Workpiece support according to any of Claims 1 to 8, **characterized in that** the driver of at least one turntable continuously engages the at least one workpiece holder.

14. Workpiece support according to Claim 13, **characterized in that** the driver is in the form of a driver ring having an inner tooth system, in particular in the form of a cylindrical metal sheet having a tooth profile.

15. Workpiece support according to any of Claims 1 to 14, **characterized in that** at least one predetermined breaking point is provided on at least one turntable (2), at which predetermined breaking point the force transmission between the shaft (1) and the turntable (2) or between the stop and the at least one workpiece holder (3) via the driving device (8) is interrupted in the event of overload.

16. Workpiece support according to any of Claims 1 to 15, **characterized in that** it has at least one turntable (2) whose driver intermittently engages the at least one workpiece holder (3), and at least one further turntable whose driver continuously engages the at least one workpiece holder.

## Revendications

1. Porte-pièce pour une installation de revêtement, avec une base dans laquelle est ancrée tournante sur un axe de rotation principal au moins une tige entraînable (1) sur laquelle sont montés rigides en torsion plusieurs plateaux (2) espacés les uns des autres d'une distance réglable dans la direction de l'axe, chacun desdits plateaux portant au moins un logement de pièce (3), lequel est monté tournant sur le plateau (2) sur un axe de rotation parallèle à l'axe de rotation principal, ainsi qu'avec des tocs d'entraînement dont chacun est affecté à un plateau (2), de telle sorte qu'il s'engrène au moins par intermittence avec ledit au moins un logement de pièce (3) et engendre de ce fait la rotation de celui-ci sur son axe de rotation, **caractérisé en ce que** le toc d'entraînement affecté à un plateau (2) appartient respectivement à un dispositif d'entraînement (8) fixé tournant sur l'axe de rotation principal, mais par ailleurs indéplaçable, sur le plateau (2), ledit dispositif d'entraînement coopérant avec une butée ancrée à la base et destinée à limiter au moins d'un côté la torsion dudit dispositif d'entraînement.

2. Porte-pièce selon la revendication 1, **caractérisé en ce que** le toc d'entraînement s'engrène avec le côté dudit au moins un logement de pièce (3) qui est respectivement opposé à l'axe de rotation principal.

3. Porte-pièce selon la revendication 1 ou 2, **caractérisé en ce que** la position du toc d'entraînement par rapport aux logements de pièce (3) est ajustable.

4. Porte-pièce selon l'une des revendications 1 à 3, **caractérisé en ce que** la butée pour tous les dispositifs d'entraînement (8) est constituée par une barre (18) parallèle à la tige (1), chacun desdits dispositifs d'entraînement présentant un prolongement (11) qui dépasse sur le bord du plateau correspondant (2) et qui s'engrène avec la barre (18).

5. Porte-pièce selon la revendication 4, **caractérisé en ce que** le prolongement (11) présente un évidement (17) en forme d'entaille, qui reçoit la barre (18).

6. Porte-pièce selon l'une des revendications 1 à 5, **caractérisé en ce que** le dispositif d'entraînement (8) est monté respectivement sur la face inférieure du plateau (2).

7. Porte-pièce selon l'une des revendications 1 à 6, **caractérisé en ce que** le dispositif d'entraînement (8) comprend une bague rotative (9) coaxiale avec le plateau (2).

8. Porte-pièce selon les revendications 6 et 7, **caractérisé en ce que** sur la face inférieure du plateau (2) est fixé un support de bague (10) situé à l'intérieur de la bague rotative (9) et prenant cette dernière par le bas.

9. Porte-pièce selon l'une des revendications 1 à 8, **caractérisé en ce que** le toc d'entraînement d'au moins un plateau (2) s'engrène par intermittence avec l'au moins un logement de pièce (3).

10. Porte-pièce selon la revendication 9, **caractérisé en ce que** le toc d'entraînement est conçu comme doigt d'entraînement (16) dirigé vers le bord du plateau (2).

11. Porte-pièce selon la revendication 10, **caractérisé en ce que** le doigt d'entraînement (16) repose sur une bague de fixation (13), laquelle est fixée, par une vis de fixation (14), sur un ergot (12) essentiellement parallèle à la tige (1).

12. Porte-pièce selon la revendication 11, **caractérisé en ce que** le doigt d'entraînement (16) est monté déplaçable longitudinalement sur la bague de fixation (13) et peut être bloqué par une vis de blocage (15).

13. Porte-pièce selon l'une des revendications 1 à 8, **caractérisé en ce que** le toc d'entraînement d'au moins un plateau s'engrène en continu avec l'au moins un logement de pièce.

14. Porte-pièce selon la revendication 13, **caractérisé en ce que** le toc d'entraînement est conçu comme couronne d'entraînement à denture intérieure, notamment comme tôle cylindrique à profil denté.

15. Porte-pièce selon l'une des revendications 1 à 14, **caractérisé en ce que** sur au moins un plateau (2) est prévu au moins un point destiné à la rupture, sur lequel la transmission de force motrice entre la tige (1) et le plateau (2) ou entre la butée et l'au moins un logement de pièce (3) par le dispositif d'entraînement (8) est interrompue en cas de surcharge.

16. Porte-pièce selon l'une des revendications 1 à 15, **caractérisé en ce qu'**il présente au moins un plateau (2) dont le toc d'entraînement s'engrène par intermittence avec l'au moins un logement de pièce (3), ainsi qu'au moins un plateau supplémentaire dont le toc d'entraînement s'engrène en continu avec l'au moins un logement de pièce.
